# EUROPÄISCHE PATENTSCHRIFT

(11) **EP 0 843 891 B1**
(45) Veröffentlichungstag und Bekanntmachung des Hinweises auf die Patenterteilung: **10.07.2002**
(21) Anmeldenummer: 96934341.7
(22) Anmeldetag: 07.08.1996
(51) Int. Cl.: H01L 21/8247, H01L 21/336

(54) **HERSTELLUNGSVERFAHREN FÜR EINE NICHTFLÜCHTIGE SPEICHERZELLE**
PROCESS FOR PRODUCING A NON-VOLATILE MEMORY CELL
PROCEDE DE FABRICATION D'UNE CELLULE DE MEMOIRE REMANENTE

(30) Priorität: 07.08.1995 DE 19528991
(43) Veröffentlichungstag der Anmeldung: 27.05.1998
(73) Patentinhaber: Infineon Technologies AG, 81669 München (DE)
(72) Erfinder: PLASA, Gunther, D-83233 Bernau (DE)
(74) Vertreter: Kindermann, Peter, Dipl.-Ing.
(86) Internationale Anmeldenummer: DE9601477
(87) Internationale Veröffentlichungsnummer: WO9706559

(56) Entgegenhaltungen:
- EP-A- 0 294 699
- IEEE TRANSACTIONS ON ELECTRON DEVICES, Bd. 28, Nr. 1, Januar 1981, NEW YORK US, Seiten 77-82, XP002024442 T. HOSOYA ET AL.: "A Self-Aligning Contact Process for MOS LSI"
- IEEE TRANSACTIONS ON ELECTRON DEVICES, Bd. 31, Nr. 10, Oktober 1984, NEW YORK US, Seiten 1413-1419, XP002024443 H. NOZAWA ET AL.: "Characteristics and Reliability of the SEPROM Cell"
- PATENT ABSTRACTS OF JAPAN vol. 006, no. 111 (E-114), 22.Juni 1982 & JP 57 042169 A (TOSHIBA CORP), 9.März 1982,

## Beschreibung

Die Erfindung betrifft ein Herstellungsverfahren für eine nichtflüchtige Speicherzelle in einem integrierten Schaltkreis ausgehend von einer ganzflächigen Siliziumschicht auf einem Dielektrikum.

Nichtflüchtige Speicherzellen sind EEPROMs und Flash-EEPROMs. Bei der Siliziumschicht kann es sich um monokristallines, polykristallines oder amorphes Silizium handeln. Als Dielektrikum verwendet man üblicherweise Siliziumdioxid, z.B. als Gateoxid, oder Siliziumnitrid.

Bei der Herstellung von derartigen Speicherzellen wird im allgemeinen im Verlauf der ersten Verfahrensschritte eine Polysiliziumschicht für die folgende Strukturierung auf einem Dielektrikum erzeugt. Die gewünschte Strukturierung, insbesondere von Transistorgates, erfolgt mittels Fotolithographie. Die dabei verwendeten Ätzprozesse stellen sehr hohe Anforderungen an den Fotolack, besonders die naßchemischen Ätzprozesse erzeugen relativ große, stark streuende Unter-ätzungen und führen prinzipiell zu konkaven Polysiliziumkanten, die unter fertigungstechnischen und Planarisierungsaspekten nur schwer zu behandeln sind.

Bei Polysilizium-Ätzprozessen besteht die Gefahr, daß das unter dem Polysilizium liegende Gateoxid geschädigt werden kann. Da außerdem bei der Ätzung systembedingt die Selektivität zwischen dem Polysilizium und dem Siliziumoxid ungenügend ist, wird das Gateoxid außerhalb der Gatebereiche in den später zu erzeugenden Source/Drain-Bereichen unreproduzierbar gedünnt, so daß es für eine definierte Source/- Drain/Implantation vollständig entfernt und durch ein neu zu bildendes Oxid ersetzt werden muß. Es ist hierfür ein weiterer naßchemischer Ätzungsprozeß erforderlich.

Diese letztgenannte Ätzung erzeugt eine Hohlkehle im Gateoxid unter der Polysiliziumgatekante, die einen inhomogenen, schwer zu kontrollierenden Übergang vom Gate zum Source/- Drainbereich mit entsprechenden Ausbeute- und Zuverlässigkeitsrisiken für den Transistor erzeugt. Im Hinblick auf die Reinigung und auf das Oxidationsverhalten ist eine derartige Hohlkehle prozeßtechnisch nur schwer zu beherrschen. Insbesondere die Isolationsfestigkeit eines darauf gebildeten Isolationsoxids zu einer zweiten Polysiliziumschicht, beispielsweise in einem EEPROM-Prozeß, wird durch diese Tatsache negativ beeinflußt.

Es ist ferner aus DE 27 39 662 A1 zur Herstellung von MOS-Transistoren bekannt, die Siliziumschicht mit einer als Oxidationsschutz dienenden Schicht zu belegen, die Oxidationsschutzschicht mittels Fotolithographie zur Herstellung einer Maske mittels Ätzung der Oxidationsschutzschicht und Freilegung des Polysiliziums in den nicht maskierten Bereichen zu strukturieren, und das Polysilizium in den freigelegten Bereichen in Siliziumdioxid durch lokale Oxidation umzuwandeln.

Aus der Zusammenfassung zur JP 57-42169(A) ist ein Verfahren zur Herstellung einer nichtflüchtigen Speicherzelle mit einem Transistor und einem Kondensator bekannt. Ausgehend von einer ganzflächigen Siliziumschicht wird auf diese Siliziumschicht eine Oxidationsschutzschicht aus Siliziumnitrid aufgebracht. Die Oxidationsschutzschicht wird mittels Fotolithografie zur Herstellung einer den Gatebereich und einen Feldbereich des Transistors abdeckenden Maske mittels Ätzung der Oxidationsschutzschicht und Freilegung des Polysiliziums in den nicht maskierten

Bereichen strukturiert. Das Polysilizium in den von der Oxidationsschutzschicht freigelegten Bereichen wird durch lokale Oxidation in Siliziumdioxid umgewandelt. Danach wird die Oxidationsschutzschicht entfernt und an ihrer Stelle eine Isolationsschicht aufgebracht, die auch über dem Feldoxid das Dielektrikum des Kondensators bildet. Das darunter liegende Polysilizium bildet eine erste Elektrode des Kondensators. Anschließend wird eine weitere Polysiliziumschicht unter Einschluss der Isolationsschicht aufgebracht. Die weitere Polysiliziumschicht wird strukturiert, so dass für den Transistor eine Steuerelektrode gebildet wird, die gleichzeitig die zweite Elektrode des Kondensators ist.

Aus dem Artikel "A Self-Aligning Contact Process for MOS LSI", Tetsuo Hosoya u.a., Transactions on electron devices, Band 28, Nr. 1, Januar 1981, Seite 77 bis Seite 82 und dem Artikel "Characteristics and Reliability of the SEPROM cell", H. Nozawa u.a., Transaction on electron devices, Band 31, Nr. 10, Oktober 1984, Seite 1413 bis Seite 1419 sind Herstellungsverfahren für eine flüchtige Speicherzelle bzw. für einenichtflüchtige Speicherzelle bekannt.

Aus der EP 0 294 699 A2 ist ein Verfahren zum Herstellen eines Kondensators in einem CMOS und in einem NMOS Prozess bekannt.

Der Erfindung liegt die Aufgabe zugrunde, ein einfaches Herstellungsverfahren für eine nichtflüchtige Speicherzelle mit Transistor und Kondensator anzugeben.

Diese Aufgabe wird durch ein herstellungsverfahren gemäß Auspruch gelöst.

Ein Grundgedanke der Erfindung ist somit darin zu sehen, daß die Strukturierung des Polysiliziums, d.h. die Entfernung von nicht notwendigen Polysiliziumflächen, nicht durch das herkömmliche Ätzen, sondern durch Umwandlung in Siliziumdioxid erreicht wird. Die Erfindung hat den Vorteil, daß keine Gateoxid-Uberätzung und keine damit verbundene Hohlkehlenbildung unter der Polysiliziumkante entsteht, so daß im Fall von MOS-Transistoren ein homogener Übergang im Gateoxid vom Gatebereich zum Source/Drain-Bereich gegeben ist. Darüber hinaus ist die Polysiliziumseitenflanke vollständig in einem homogen gewachsenen Oxid eingebettet, dessen Dicke etwa mindestens der des Polysiliziums entspricht. Die Isolationsfestigkeit zu einer ggf. darüberliegenden zweiten Polysiliziumschicht, wie beispielsweise bei einem EEPRCM, wird dadurch nur noch durch die planare und deswegen leicht zu kontrollierende Dicke der ursprünglich als Strukturierungsmaske für die erste Polysiliziumschicht dienende Nitridschicht oder ggf. eines anderen Dielektrikums bestimmt, da der begrenzende Einfluß der Polysiliziumflanke nicht mehr vorhanden ist.

Ferner wird mit der Erfindung der bei herkömmlichen Verfahren vorhandene Nachteil bei MOS-Transistoren vermieden, daß aufgrund eines prozeßbedingten abrupten Überganges in der Gateoxiddicke an der Gatekante vom Gate zum Source/Drain-Bereich zu einer lokal höheren Feldstärke zwischen der Gatekante und dem Source/Drain-Bereich führt. Es wird vielmehr durch den Oxidationsvorgang ein stetiger Anstieg der Gateoxiddicke am Übergang vom Gate zum Source/Drain-Bereich erzeugt. Dadurch werden lokale Feldstärkespitzen mit der Folge einer verstärkten Degradation der Transistorparameter in diesem kritischen Bereich vermieden. Die Transistor-zuverlässigkeit wird auf diese Weise erhöht, insbesondere bei höheren Betriebsspannungen, wie sie z.B. bei EEPROM-Anwendungen üblich sind.

Da die mit der erfindungsgemäßen Oxidation erzeugte Polysiliziumkante ein konvexes Profil hat, trägt auch diese konvexe Gatekante zur Vermeidung der lokalen Feldstärkespitzen und damit zur besseren Transistorzuverlässigkeit bei.

Mit der Erfindung erzielt man ferner eine genügend hohe Durchbruchspannung der Source/Drain-Gebiete, die beispielsweise wiederum in EEPROM-Anwendungen sehr vorteilhaft ist. Es können daher in Kombinationsprozessen, beispielsweise bei der Herstellung von sogenannten Embedded Memories, üblicherweise zu einem späteren Zeitpunkt hergestellte Source/Drain-Bereiche von Niedervoltlogik-Transistoren mit weniger Anforderungen an die Spannungsfestigkeit unabhängig hergestellt und optimiert werden. Bei der Herstellung von MOS-Transistoren ist es vorteilhaft, daß vor Entfernung der bei der Fotolithographie verwendeten Fotolackmaske die Source/Drain-Implantation durch das freigelegte Silizium hindurch erfolgt. Der für die hohe Durchbruchspannung verantwortliche geringe Dotierungsgradient der Source/Drain-Diffusion für beispielsweise EEPROM-Anwendungen beruht darauf, daß die Implantation relativ am Anfang des gesamten Herstellungsprozesses und vor der Oxidation des Polysiliziums stattfindet, welche das implantierte Siliziumdioxid aktiviert und es in das Siliziumsubstrat eintreibt.

Es wird mit der Erfindung auch der Nachteil von herkömmlichen Ätzverfahren vermieden, bei welchen die systembedingte Spalte zwischen den Polysiliziumbahnen zu Planarisierungsproblemen in den nachfolgenden Ebenen führen. Sie können nur mit großem Aufwand mittels Abscheidung und Rückätzung sowie chemischmechanischem Polieren gelöst werden. Dagegen hat die Erfindung den Vorteil, daß zwischen benachbarten Polysiliziumbahnen eine Auffüllung mit Siliziumoxid vorhanden ist, das aus dem ohnehin nicht gebrauchten, zu entfernenden Polysilizium an dieser Stelle gebildet wurde. Es können damit zusätzliche Verfahrensschritte zum Planarisieren eingespart werden.

Mit der Erfindung wird auch der Nachteil von herkömmlichen Ätzverfahren überwunden, die auf dem Feldoxid in denjenigen Bereichen, wo das Polysilizium entfernt wurde, zu einer Dünnung des Feldoxids und entsprechendem Absinken der Feldoxid-Isolationseigenschaften führen. Dieser Verlust muß dann durch eine Erhöhung der Felddotierung ausgeglichen werden, die aber wiederum wegen der resultierenden Erhöhung des Dotierungsgradienten an der Locos-Kante bestimmte Transistoreigenschaften, wie beispielsweise Durchbruch und Narrow-Width-Eigenschaften, negativ beeinflussen kann. Im Unterschied dazu hat die Erfindung den Vorteil, daß auch in den Feldbereichen nicht benötigtes Polysilizium in Oxid umgewandelt wird, so daß sich dort die Feldoxiddicke um den entsprechenden Betrag erhöht. Die Dickenerhöhung entspricht im wesentlichen der ursprunglichen Polysiliziumdicke. Dadurch erhöht sich ggf. die Einsatzspannung eines parasitären Feldoxidtransistors für die darüberliegenden Ebenen, wie beispielsweise die Metallisierungen, oder eine evtl. zweite Polysiliziumebene.

Eine bevorzugte Ausbildunc besteht darin, daß die Oxidationsschutzschicht mindestens eine Nitridschicht aufweist.

Besonders gute Ergebnisse werden dadurch erzielt, daß die Nitridschicht als Oxidnitrid (ON)-Sandwich oder als Oxid-Nitrid-Oxid-Sandwich-Schicht (ONO-Schicht) oder als nitridierte Oxidschicht ausgebildet wird. Da alle diese Maskierschichten sehr dünn sein können, ist deren Atzung auch mit einfachen naßchemischen Mitteln bei tolerierbarem Maßverlust möglich. An die Stabilität des Fotolacks werden daher nur geringe Anforderungen gestellt.

Nachfolgend wird die Erfindung anhand eines in der Zeichnung dargestellten Ausführungsbeispieles weiter beschrieben. Es zeigen:

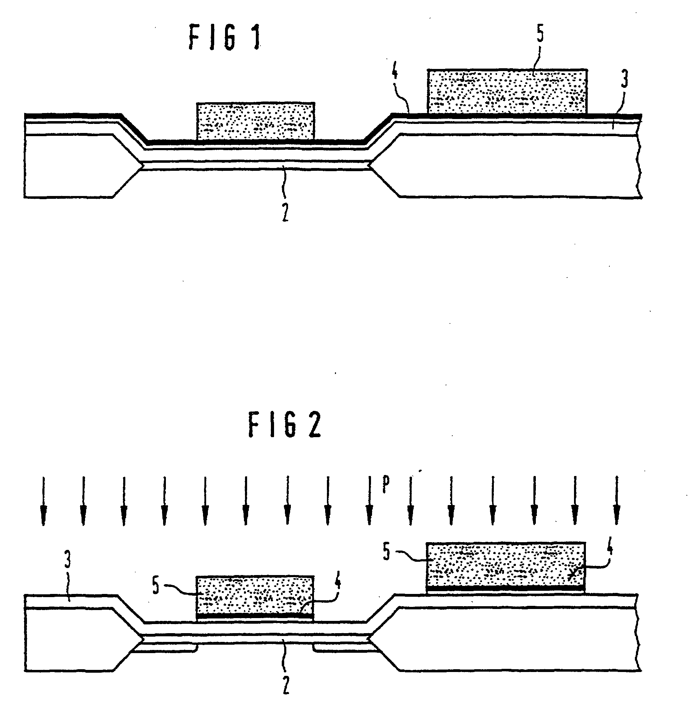

Figur 1 bis Figur 5 jeweils schematisch einen Verfahrensschritt bei der Herstellung eines Transistors und eines Kondensators als EEPROM-Speicherzelle.

Auf einen Siliziumsubstrat 1 liegt in den Source/Drain-Bereichen und zwischen dem Feldoxid eine Siliziumoxidschicht 2.

Gemäß Figur 1 wird auf der Siliziumoxidschicht 2 eine Polysiliziumschicht 3 (Poly1) erzeugt. Darauf wird eine Oxid-Nitrid-Schicht 4 (ON) sowie anschließend eine Fotolackmaske 5 aufgebracht. Die Fotolackmaske 5 entspricht den gewünschten Polysilizium-Strukturen und läßt die Source/Drain-Bereiche frei. Es wird anschließend die Oxid-Nitrid-Schicht 4 an den lackfreien Stellen mit einem Atzprozeß entfernt, so daß die Polysiliziumschicht 3 an diesen Stellen freigelegt wird.

Unmittelbar nach der Ätzung und unter Beibehaltung der Fotolackmaske 5 erfolgt gemäß Fig. 2 eine Implantation der Source/Drain-Bereiche, in dem dargestellten Beispiel mit Phosphor, durch die freiliegende Polysiliziumschicht 3.

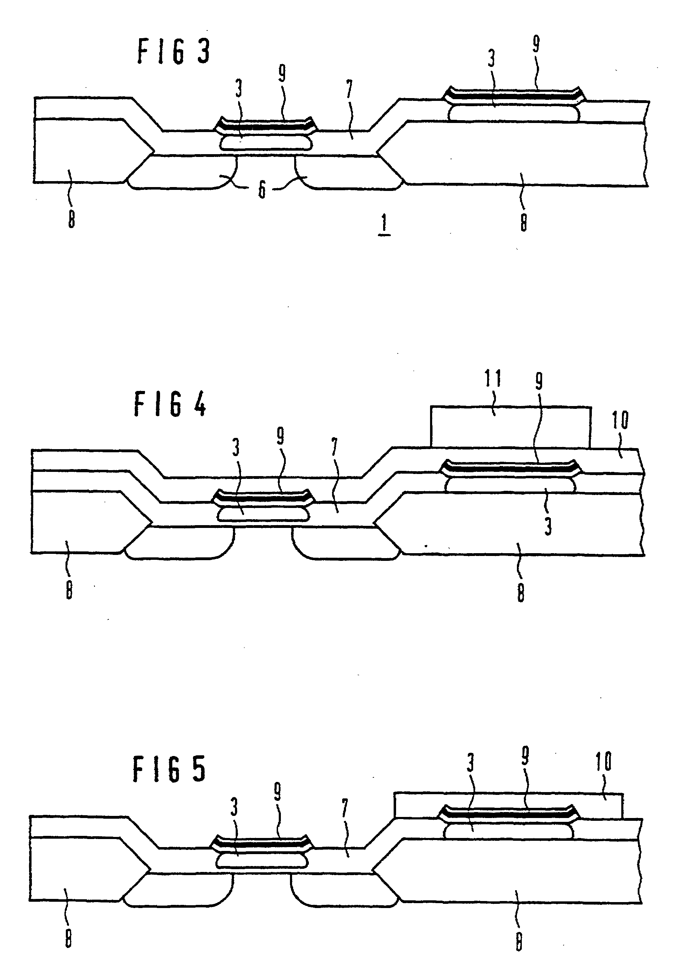

Anschließend wird nach Entfernung der Fotolackmaske 5 gemäß Figur 3 beim freiliegenden Polysilizium durch eine thermische Oxidation bei entsprechend ausgewählten Temperatur-/Gasbedingungen eine Umwandlung in Siliziumdioxid 7 vorgenommen, wobei die Oxid-Nitrid-Schicht 4 mit der gemäß Figur 1 erzeugten Struktur als Maske dient. Zum Abschluß der Oxidation hat die entstandene Polysiliziumkante ein konvexes Profil. Im übrigen wird bei der Oxidation das implantierte Element 6 aktiviert und in das Siliziumsubstrat 1 eingetrieben. Nach Abschluß der oxidation sind die Zwischenraume zwischen der Polysilizium-Struktur mit thermischem Siliziumdioxid aufgefüllt und das ursprünglich vorhandene Polysilizium ist an dieser Stelle vollständig durchoxidiert.

Auch über den Feldbereichen 8 ist das nicht gebrauchte Polysilizium in Siliziumdioxid 7 umgewandelt, so daß sich dort die Feldoxiddicke um etwas mehr als einen der ursprünglichen Polysiliziumdicke entsprechenden Betrag erhöht hat. Es ist ferner durch oberflächliche Oxidation der Nitridschicht aus der Oxid-Nitridschicht 4 ein Oxid-Nitrid-Oxid-Sandwich 9 entstanden.

Gemäß Figur 4 wird der Herstellungsprozeß fortgeführt, indem eine zweite Polysiliziumschicht 10 zur Herstellung einer Kapazität zwischen der ersten und zweiten Polysiliziumschicht 3, 10 aufgebracht wird. Darauf wird eine weitere Fotolackmaske 11 über dem Kondensatorbereich aufgebracht und strukturiert. Mit der Fotolackmaske 11 wird die zweite Polysiliziumschicht 10 als obere Elektrode der gewünschten Kapazität erzeugt. Aus der Figur 5 wird in diesem Zusammenhang ersichtlich, daß die Durchbruchfeldstarken nur durch die Eigenschaften der planaren ONO-Schicht 9 bestimmt werden. Ferner ist außerhalb der aktiven Gebiete die effektive Feldoxiddicke um den Betrag dieser Feldoxiddicke erhöht.

## Patentansprüche

1. Herstellungsverfahren für eine nichtflüchtige Speicherzelle mit einem Transistor und einem Kondensator in einem integrierten Schaltkreis, wobei ausgehend von einer ganzflächigen Polysiliziumschicht (3)
- die Polysilizimschicht (3) mit einer Oxidationsschutzschicht (4) belegt wird,
- die Oxidationsschutzschicht (4), mittels Fotolithographie zur Herstellung einer den Gatebereich und einen Feldbereich (8) des Transistors abdeckenden Maske (5), und mittels Ätzung der Oxidationsschutzschicht (4) und Freilegung der Polysiliziumschicht (3) in den nicht maskierten Bereichen strukturiert wird,
- die Polysiliziumschicht (3) in den von der Oxidationsschutzschicht freigelegten Bereichen in Siliziumdioxid (7) durch lokale Oxidation umgewandelt wird, wobei die über dem Feldbereich (3) verbleibende Oxidationsschutzschicht (4) das Dielektrikum und das darunter liegende Polysilizium (3) eine erste Elektrode des Kondensators bilden,
- eine weitere Polysiliziumschicht (10) unter Einschluß der verbliebenen Oxidationsschutzschicht aufgebracht wird,
- eine Fotolackmaske (11) aufgebracht und in der Weise strukturiert wird, daß ein über dem Feldbereich liegender Bereich der weiteren Polysiliziumschicht zur Formung der zweiten Elektrode des Kondensators abgedeckt wird,
- mittels Ätzung der weiteren Polysiliziumschicht (10) in den nicht maskierten Bereichen die zweite Elektrode des Kondensators hergestellt wird.

2. Herstellungsverfahren nach Anspruch 1,
**dadurch gekennzeichnet,**
**daß** die Oxidationsschutzschicht (4) in den für den weiteren Herstellungsprozeß nicht erforderlichen Bereichen entfernt wird.

3. Herstellungsverfahren nach Anspruch 1 oder 2,
**dadurch gekennzeichnet**
**daß** die Umwandlung der Polysiliziumschicht (3) durch thermische Oxidation erfolgt.

4. Herstellungsverfahren nach einem der vorhergehenden Ansprüche,
**dadurch gekennzeichnet,**
**daß** die Oxidationsschutzschicht (4) aus mindestens einer Nitridschicht besteht.

5. Herstellungsverfahren nach einem der vorhergehenden Ansprüche,
**dadurch gekennzeichnet,**
**daß** die Nitridschicht (4) aus Oxidnitrid oder einem Oxid-Nitrid-Sandwich oder einem Oxid-Nitrid-Oxid besteht.

6. Herstellungsverfahren nach einem der vorhergehenden AnSprüche,
**dadurch gekennezeichnet,**
daß bei der Herstellung eines MOS-Transistors vor Entfernen der bei der Fotolithographie verwendeten Maske (5) die Source/Drain-Implantation durch die freigelegte Polysiliziumschicht (3) hindurch erfolgt.

7. Herstellungsverfahren Anspruch 6,
**dadurch gekennzeichnet**
**daß** die Umwandlung der Polysiliziumschicht (3) in Siliziumdioxid in den Source/Drain-Bereichen sowie in Feldoxidbereichen erfolgt.

8. Herstellungsverfahren nach einem der vorhergehenden Ansprüche,
**dadurch gekennezeichnet**, dass die den Gatebereich und den Feldbereich abdeckende Maske (5) die Source-Drain-Bereiche frei läßt.

## Claims

1. Method for producing a non-volatile memory cell having a transistor and a capacitor in an integrated circuit, in which case, starting from a whole-area polysilicon layer (3),
- the polysilicon layer (3) is covered with an oxidation protection layer (4),
- the oxidation protection layer (4) is patterned by means of photolithography in order to produce a mask (5) which covers the gate region and a field region (8) of the transistor, and by means of etching the oxidation protection layer (4) and uncovering the polysilicon layer (3) in the unmasked regions,
- the polysilicon layer (3) in the regions that have been freed from the oxidation protection layer is converted into silicon dioxide (7) by means of local oxidation, the oxidation protection layer (4) remaining over the field region (3) forming the dielectric and the underlying polysilicon (3) forming a first electrode of the capacitor,
- a further polysilicon layer (10) is applied, with inclusion of the remaining oxidation protection layer,
- a photoresist mask (11) is applied and patterned in such a way as to cover a region, situated above the field region, of the further polysilicon layer for forming the second electrode of the capacitor,
- the second electrode of the capacitor is produced by means of etching the further polysilicon layer (10) in the unmasked regions.

2. Production method according to Claim 1, **characterized in that** the oxidation protection layer (4) is removed in the regions not required for the rest of the production process.

3. Production method according to Claim 1 or 2, **characterized in that** the conversion of the polysilicon layer (3) is effected by means of thermal oxidation.

4. Production method according to one of the preceding claims, **characterized in that** the oxidation protection layer (4) comprises at least one nitride layer.

5. Production method according to one of the preceding claims, **characterized in that** the nitride layer (4) comprises oxide-nitride or an oxide-nitride sandwich or an oxide-nitride-oxide.

6. Production method according to one of the preceding claims, **characterized in that** in the event of production of a MOS transistor, before the removal of the mask (5) used during the photolithography, the source/drain implantation is effected through the uncovered polysilicon layer (3).

7. Production method according to Claim 6, **characterized in that** the conversion of the polysilicon layer (3) into silicon dioxide is effected in the source/drain regions and also in field oxide regions.

8. Production method according to one of the preceding claims, **characterized in that** the mask (5) which covers the gate region and the field region leaves the source-drain regions free.

## Revendications

1. Procédé de fabrication d'une cellule de mémoire rémanente comprenant un transistor et un condensateur dans un circuit intégré, dans lequel en partant d'une couche (3) de polysilicium sur toute une surface
- on garnit la couche (3) de polysilicium d'une couche (4) de protection vis-à-vis de l'oxydation,
- on structure la couche (4) de protection vis-à-vis de l'oxydation au moyen d'une photolithographie pour ménager un masque (5) recouvrant la zone de grille et une zone (8) de champ du transistor et au moyen d'une attaque de la couche (4) de protection vis-à-vis de l'oxydation et de la mise à nu de la couche (3) de polysilicium dans les parties non masquées,
- on transforme la couche (3) de polysilicium dans les parties mises à nu de la couche de protection vis-à-vis de l'oxydation en dioxyde (7) de silicium par oxydation locale, la couche (4) de protection vis-à-vis de l'oxydation restant sur la zone (3) de champ, le diélectrique et le polysilicium (3) sous-jacent formant une première électrode du condensateur,
- on dépose une autre couche (10) de polysilicium en incluant la couche de protection vis-à-vis de l'oxydation qui reste,
- on dépose un masque (11) en vernis photosensible et on le structure de manière à recouvrir une partie se trouvant au-dessus de la zone de champ de l'autre couche de polysilicium pour former la deuxième électrode du condensateur,
- on ménage au moyen d'une attaque de l'autre couche (10) de polysilicium dans les parties non masquées, la deuxième électrode du condensateur.

2. Procédé de fabrication suivant la revendication 1, **caractérisé en ce que** l'on élimine la couche (4) de protection vis-à-vis de l'oxydation dans les parties qui ne sont pas nécessaires pour le reste de l'opération de fabrication.

3. Procédé de fabrication suivant la revendication 1 ou 2, **caractérisé en ce que** l'on effectue la transformation de la couche (3) de polysilicium par oxydation thermique.

4. Procédé suivant l'une des revendications précédentes, **caractérisé en ce que** la couche (4) de protection vis-à-vis de l'oxydation est constituée d'au moins une couche de nitrure.

5. Procédé de fabrication suivant l'une des revendications précédentes, **caractérisé en ce que** la couche (4) de nitrure est constituée d'oxyde de nitrure ou d'un stratifié d'oxyde de nitrure ou d'un oxyde-nitrure-oxyde.

6. Procédé de fabrication suivant l'une des revendications précédentes, **caractérisé en ce que** lors de la fabrication d'un transistor MOS, avant d'éliminer le masque (5) utilisé pour la photolithographie, on effectue l'implantation de source/drain à travers la couche (3) de polysilicium mise à nue.

7. Procédé de fabrication suivant la revendication 6 **caractérisé en ce que** l'on effectue la transformation de la couche (3) de polysilicium en dioxyde de silicium dans les zones de source/drain ainsi que dans les zones d'oxyde de champ.

8. Procédé de fabrication suivant l'une des revendications précédentes, **caractérisé en ce que** le masque (5) recouvrant la zone de grille et la zone de champ laisse dégagées les zones de source/drain.
